# EUROPÄISCHE PATENTSCHRIFT

(11) **EP 0 496 910 B1**
(45) Veröffentlichungstag und Bekanntmachung des Hinweises auf die Patenterteilung: **27.03.1996**
(21) Anmeldenummer: 91101146.8
(22) Anmeldetag: 29.01.1991
(51) Int. Cl.: H03K 17/22

(54) **Schaltungsanordnung zur Generierung eines Rücksetzsignals**
Circuit arrangement for generating a power-on reset signal
Montage servant à générer un signal de remise à zéro

(43) Veröffentlichungstag der Anmeldung: 05.08.1992
(73) Patentinhaber: SIEMENS AKTIENGESELLSCHAFT, D-80333 München (DE)
(72) Erfinder: Bacigalupo, Tommaso, Dipl.-Ing., W-8038 Gröbenzell (DE)

(56) Entgegenhaltungen:
- EP-A- 0 150 480
- US-A- 4 818 904
- IEEE JOURNAL OF SOLID-STATE CIRCUITS. Bd. SC-12, Nr. 5, Oktober 1977, NEW YORK US Seiten 502 - 506; STEWART: 'High-density CMOS ROM arrays '

## Beschreibung

Die Erfindung betrifft eine Schaltungsanordnung zur Generierung eines Rücksetzsignals.

Nach dem Einschalten der Betriebsspannung befinden sich digitale integrierte Schaltungen in einem undefinierten Zustand. Durch ein Rücksetzsignal, das üblicherweise durch eine externe Logik erzeugt und der integrierten Schaltung über einen externen Rücksetzeingang zugeführt wird, erfolgt die Initialisierung der integrierten Schaltung. Der Vorteil einer externen Logik zur Erzeugung des Rücksetzsignales besteht darin, daß die externe Logik an Besonderheiten der Spannungsversorgung, vor allem hinsichtlich des Verlaufs des Spannungsanstiegs beim Einschalten, genauestens angepaßt werden kann. Nachteil ist jedoch der zusätzlich notwendige Schaltungsaufwand.

Aus IEEE Journal of Solid-State Circuits, Bd. SC-12, Nr. 5, Oktober 1977, New York, Seiten 502-506, R.G. Stewart: "High density CMOS RAM arrays" ist eine mitintegrierbare Schaltungsanordnung zur Generierung eines Rücksetzsignals bekannt, welche ein bistabiles Schaltelement aufweist, das beim Anlegen einer Versorgungsspannung einen Vorzugszustand einnimmt und bei der ein Ausgang beim Vorzugszustand das Rücksetzsignal führt. Zwischen Ausgang und Eingang des bistabilen Schaltelementes ist eine ein- und ausschaltbare Verzögerungsleitung geschaltet, wobei bei Überschreiten der Gate-Source-Schwellenspannungen zweier Transistoren durch die Versorgungsspannung das bistabile Schaltelement aus der Vorzugslage gekippt wird.

Aufgabe der Erfindung ist es, eine mitintegrierte Schaltungsanordnung zur Generierung eines Rücksetzsignals anzugeben, die weitgehenst unabhängig vom Einschaltverhalten der Versorgungsspannung ist.

Diese Aufgabe wird durch eine Schaltungsanordnung gemäß Patentanspruch 1 gelöst. Ausgestaltungen und Weiterbildungen des Erfindungsgedankens sind Gegenstand von abhängigen Ansprüchen.

Vorteile derartiger Schaltungsanordnungen sind, daß sie mit verschiedenen CMOS-Technologien leicht integrierbar sind, daß bei aktivem Rücksetzsignal ein geringer Versorgungsstrom und bei inaktivem Rücksetzsignal praktisch kein Versorgungsstrom fließt und daß der Anstieg der Versorgungspannung auf ihren Nennwert innerhalb einer relativ langen Zeitspanne erfolgen darf.

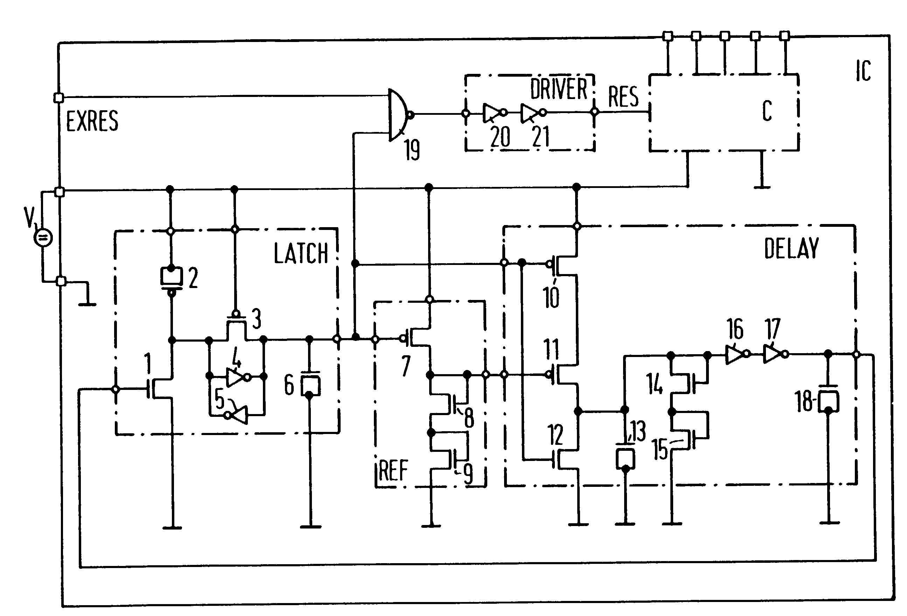

Die Erfindung wird nachfolgend anhand des in der einzigen Figur der Zeichnung dargestellten Ausführungsbeispiels näher erläutert.

Eine erfindungsgemäße Schaltungsanordnung zur Generierung eines Rücksetzsignals RES besteht mindestens aus einem bistabilen Schaltelement LATCH, aus einer ein- und ausschaltbaren Referenzspannungsquelle REF und aus einer ein- und ausschaltbaren Verzögerungsleitung DELAY. Das bistabile Schaltelement LATCH ist dabei so ausgebildet, daß dieses beim Anlegen einer Versorgungsspannung V einen Vorzugszustand einnimmt. An den Ausgang des bistabilen Schaltelements LATCH ist ein Steuereingang der ein- und ausschaltbaren Referenzspannungsquelle REF angeschlossen. Beim Vorzugszustand des bistabilen Schaltelements LATCH ist die Referenzspannungsquelle REF eingeschaltet und andernfalls ausgeschaltet. Mit dem Ausgang der Referenzspannungsquelle REF ist ein Referenzeingang der Verzögerungsleitung DELAY verbunden, deren Referenzeingang mit dem Ausgang des bistabilen Schaltelements LATCH und dessen Ausgang mit einem Eingang des bistabilen Schaltelements LATCH gekoppelt ist.

Weiterhin ist an den Ausgang des bistabilen Schaltelements LATCH ein Eingang eines NAND-Gatters 19 angeschlossen, dessen anderer Eingang mit einem externen Rücksetzsignal EXRES beaufschlagt ist. Dem Ausgang des NAND-Gatters 19 ist eine Treiberstufe DRIVER nachgeschaltet. Der Ausgang der Treiberstufe DRIVER führt das Rücksetzsignal RES, das an nicht näher beschriebene weitere Schaltungsteile C angelegt ist. Diese weiteren Schaltungsteile C sind, wie auch die Referenzspannungsquelle REF und die Verzögerungsleitung DELAY, an die Versorgungsspannungsquelle V angeschlossen. Die gesamte Anordnung ist einschließlich der weiteren Schaltungsteile C Bestandteil einer integrierten Schaltung IC. Neben Anschlüssen für ein externes Rücksetzsignal EXRES und für die Versorgungsspannungsquelle V sind weitere, jedoch nicht näher bezeichnete, mit den weiteren Schaltungsteilen C verbundene Anschlüsse vorgesehen.

In Weiterbildung der Erfindung besteht beim vorliegenden Ausführungsbeispiel das bistabile Schaltelement LATCH aus einem MOS-Feldeffekttransistor 1 vom N-Kanal-Typ, dessen Sourceanschluß mit einem Pol der Versorgungsspannungsquelle V verbunden ist, und dessen Gateanschluß den Eingang des bistabilen Schaltelements LATCH bildet, aus einer ersten Kapazität 2, die zwischen den anderen Pol der Versorgungsspannungsquelle V und den Drainanschluß des ersten MOS-Feldeffekttransistors 1 geschaltet ist, aus zwei antiparallel geschalteten Invertern 4 und 5 und einem dazu mit seiner Source-Drain-Strecke parallel geschalteten sowie über seinen Gateanschluß mit dem anderen Pol der Versorgungsspannungsquelle V verbundenen zweiten MOS-Feldeffekttransistors 3 vom P-Kanal-Typ, die zwischen den Ausgang des bistabilen Schaltelements LATCH und den Drainanschluß des ersten MOS-Feldeffekttransistors 1 geschaltet sind. Außerdem weist das bistabile Schaltelement LATCH eine zweite Kapazität 6 auf, die zwischen seinem Ausgang und dem einen Pol der Versorgungsspannungsquelle V geschaltet ist. Die beiden Kapazitäten 2 und 6 werden jeweils durch MOS-Feldeffekttransistoren gebildet, bei denen jeweils Sourceanschluß und Drainanschluß miteinander verbunden sind. Für die Kapazität 2 wird dabei ein MOS-Feldeffekttransistor vom P-Kanal-Typ und für die Kapazität 6 ein MOS-Feldeffekttransistor vom N-Kanal-Typ verwendet. Die beiden Inverter 4 und 5 bilden ein Speicherelement, daß beim Hochfahren der Versorgungsspannung durch eine unsymmetrische Dimensionierung der beiden Inverter 4 und 5 sowie durch die Kapazitäten 2 und 6 in einen Vorzugszustand gebracht wird. Beim gezeigten Ausführungsbeispiel ist der Vorzugszustand durch eine logische Null an Ein- und Ausgang des binären Schaltelements LATCH gegeben. In diesem Zustand ist das Resetsignal RES aktiv. Durch Ansteuern des MOS- und Feldeffekttransistors 1 mit einer logischen Eins wird das bistabile Schaltelement LATCH in seinen komplementären Zustand entsprechend einer logischen Eins am Ausgang und einem inaktiven Resetsignal RES gekippt. Wird die Spannungsversorgung V der integrierten Schaltung IC abgeschaltet, bleiben Spannungen in den Kapazitäten 2 und 6 gespeichert. Damit diese eine Initialisierung des bistabilen Speicherelementes LATCH beim nächsten Hochfahren der Versorgungsspannung nicht stören, werden sie über den MOS-Transistor 3 beim Fehlen der Versorgungsspannung kurzgeschlossen.

Weiterhin ist, die Erfindung weiterbildend, bei dem gezeigten Ausführungsbeispiel die ein- und ausschaltbare Referenzspannungsquelle REF aus einem MOS-Feldeffekttransistor 7 vom P-Kanal-Typ, dessen Sourceanschluß an den anderen Pol der Versorgungsspannungsquelle V angeschlossen ist und dessen Gateanschluß den Steuereingang und dessen Sourceanschluß den Ausgang der ein- und ausschaltbaren Referenzspannungsquelle REF bildet, sowie aus zwischen den Sourceanschluß des MOS-Feldeffekttransistors 7 und den einen Pol der Versorgungsspannungsquelle V in Reihe geschalteten Dioden 8 und 9 aufgebaut. Die Dioden 8 und 9 werden durch MOS-Feldeffekttransistoren gebildet, bei denen Drainanschluß und Gateanschluß miteinander verbunden sind. Diese beiden MOS-Feldeffekttransistoren sind als sogenannte Transistor-Dioden geschaltet und weisen in dieser Schaltungstechnik eine ähnliche Kennlinie wie herkömmliche Dioden auf. Bei einem Anstieg der Versorgungsspannung von Null auf den Nennwert nimmt die Spannung am Ausgang der ein- und ausschaltbaren Referenzspannungsquelle REF zunächst in gleichem Maße wie die Versorgungsspannung zu, da die beiden Dioden 8 und 9 in dieser Phase sperren. Sobald aber jeweils die Gate-Source-Spannung der die beiden Dioden 8 und 9 bildenden MOS-Feldeffekttransistoren ihre Einsatzspannung überschreitet, beginnen diese zu leiten. Dadurch wird die Spannung am Ausgang der ein- und ausschaltbaren Referenzspannungsquelle REF auf einen Wert von ungefähr der zweifachen Einsatzspannung begrenzt.

In Weiterbildung der Erfindung besteht die ein- und ausschaltbare Verzögerungsleitung DELAY aus einem MOS-Feldeffekttransistor 10 vom P-Kanal-Typ, dessen Drainanschluß mit dem anderen Pol der Versorgungsspannungsquelle V verbunden ist und dessen Gateanschluß den Steueranschluß der ein- und ausschaltbaren Verzögerungsleitung DELAY bildet und aus einem MOS-Feldeffekttransistor 11 vom P-Kanal-Typ, dessen Drainanschluß mit dem Sourceanschluß des MOS-Feldeffekttransistors 10 verbunden ist und dessen Gateanschluß den Referenzeingang bildet. Außerdem ist ein MOS-Feldeffekttransistor 12 vom N-Kanal-Typ vorgesehen, dessen Gateanschluß mit dem Gateanschluß des MOS-Feldeffekttransistors 10 und dessen Drainanschluß mit dem Sourceanschluß des MOS-Feldeffekttransistors 11 verbunden ist und dessen Sourceanschluß an den einen Pol der Versorgungsspannungsquelle V angeschlossen ist. Schließlich weist die ein- und ausschaltbare Verzögerungsleitung DELAY eine Kapazität 13, die dar Source-Drain-Strecke des MOS-Feldeffekttransistors 12 parallelgeschaltet ist, zwei in Reihe geschaltete Widerstände 14 und 15, die der Kapazität 13 parallelgeschaltet sind, zwei in Reihe geschaltete weitere Inverter 16 und 17, die einerseits an den Drainanschluß des MOS-Feldeffekttransistors 12 und andererseits an den Ausgang der ein- und ausschaltbaren Verzögerungsleitung DELAY angeschlossen sind, sowie eine Kapazität 18, die zwischen den Ausgang der ein- und ausschaltbaren Verzögerungsleitung DELAY und den einen Pol der Versorgungsspannungsquelle V geschaltet ist, auf. Die Kapazität 13 wird nach dem Einschalten der Versorgungsspannungsquelle V auf den Nennwert aufgeladen, wenn die beiden MOS-Feldeffekttransistoren 10 und 11 leiten, d. h. wenn die Spannungen am Ausgang des bistabilen Schaltelementes LATCH und der ein- und ausschaltbaren Referenzspannungsquelle REF die Einsatzspannung des jeweiligen MOS-Feldeffekttransistors 10 bzw. 11 überschreitet. Sobald die Spannung an der Kapazität 13 die Schaltschwelle des Inverters 16 überschreitet, schalten die beiden Inverter 16 und 17 durch und laden die Kapazität 18 auf, wodurch das Signal am Eingang des bistabilen Schaltelements LATCH gleich einer logischen Eins wird. Damit kippt das bistabile Schaltelement LATCH aus seiner Vorzugsrichtung und das Rücksetzsignal signal RES wird inaktiv. Damit in den Kapazitäten 13 und 18 keine Spannungen gespeichert bleiben, die eine erneute Generierung eines Rücksetzsignals stören können, werden sie bei inaktivem Rücksetzsignal RES mittels des MOS-Feldeffekttransistors 12 bzw. durch den Inverter 17 vollständig bzw. nahezu vollständig entladen. Bei einem sehr langsamen Anstieg der Versorgungsspannung bis in den Sekundenbereich hinein wird die Kapazität 13 durch Leckströme der MOS-Feldeffekttransistoren 7 und 8 aufgeladen, wodurch am Eingang des bistabilen Schaltelements LATCH ein Signalwechsel zu früh erfolgen könnte. Die beiden als Widerstände 14 und 15 geschalteten MOS-Feldeffekttransistoren verhindern dies, indem sie einen Entladewiderstand für die Kapazität 13 bilden. Die MOS-Feldeffekttransistoren der beiden Widerstände 14 und 15 sind zwar prinzipiell wie Dioden, beispielsweise wie die Dioden 8 und 9, geschaltet, sie weisen jedoch eine große Kanallänge und eine geringe Kanalbreite auf und wirken deshalb nur als Widerstände. Der Gateanschluß des MOS-Feldeffekttransistors 11 ist mit dem Ausgang der ein- und ausschaltbaren Referenzspannungsquelle REF verbunden. Wenn die Versorgungsspannung über die doppelte Einsatzspannung der beiden Dioden 8 und 9 hinaus weiter steigt, wird schließlich die Gate-Source-Spannung des MOS-Feldeffekttransistors 10 größer als seine Einsatzspannung und er beginnt zu leiten, wodurch die Verzögerungsleitung aktiviert wird. Das Rücksetzsignal RES bleibt ohne Berücksichtigung eines Substratsteuerfaktors mindestens so lange aktiv, bis die Versorgungsspannung einen Wert, der annähernd gleich der doppelten Einsatzspannung der Dioden 8 und 9 zuzüglich der Einsatzspannung des MOS-Feldeffekttransistors 10 ist, überschritten hat.

Schließlich wird das am Ausgang des bistabilen Schaltelements LATCH anliegende Signal über das NAND-Gatter 19 mit dem externen Rücksetzsignal EXRES verknüpft, wodurch erreicht wird, daß ein Rücksetzen der übrigen Schaltungsteile C auch nach dem Einschalten der Versorgungsspannungsquelle V möglich ist. Das Rücksetzsignal RES ist über eine Treiberstufe DRIVER geführt, die aus zwei hintereinander geschalteten Invertern 20 und 21 besteht. Damit wird zum einen eine Entkopplung des Ausgangs des bistabilen Schaltelements LATCH bzw. des NAND-Gatters 19 von den übrigen Schaltungsteilen C und zum anderen ein höherer Fan-out erreicht.

## Patentansprüche

1. Schaltungsanordnung zur Generierung eines Rücksetzsignals (RES) mit einem bistabilen Schaltelement (LATCH), das beim Anlegen einer Versorgungsspannung (V) einen Vorzugszustand einnimmt und bei der ein Ausgang beim Vorzugszustand das Rücksetzsignal (RES) führt,
mit einer ein- und ausschaltbaren Referenzspannungsquelle (REF), bei der ein Steuereingang mit dem Ausgang des bistabilen Schaltelements (LATCH) verbunden ist und die beim Vorzugszustand des bistabilen Schaltelements (LATCH) eingeschaltet ist, und mit einer ein- und ausschaltbaren Verzögerungsleitung (DELAY), bei der ein Steuereingang mit dem Ausgang des bistabilen Schaltelements (LATCH) und ein Ausgang mit einem Eingang des bistabilen Schaltelements (LATCH) verbunden ist, bei der ein Referenzeingang an die ein- und ausschaltbare Referenzspannungsquelle (REF) angeschlossen ist, die beim Vorzugszustand des bistabilen Schaltelements (LATCH) eingeschaltet ist und die nach Überschreiten eines durch die ein- und ausschaltbare Referenzspannungsquelle (V) vorgegebenen Referenzwertes durch die Versorgungsspannung (V) zeitverzögert das bistabile Schaltelement (LATCH) aus der Vorzugslage kippt.

2. Schaltungsanordnung nach Anspruch 1,
**dadurch gekennzeichnet,** daß das bistabile Schaltelement (LATCH) aus einem ersten MOS-Feldeffekttransistor (1) des einen Leitungstyps, dessen Sourceanschluß mit einem Pol der Versorgungsspannungsquelle (V) verbunden ist und dessen Gateanschluß den Eingang des bistabilen Schaltelements (LATCH) bildet, aus einer ersten Kapazität (2), die zwischen dem anderen Pol der Versorgungsspannungsquelle (V) und den Dainanschluß des ersten MOS-Feldeffekttransistors (1) geschaltet ist, aus zwei antiparallel geschalteten Invertern (4, 5) und einem dazu mit seiner Source-Drain-Strecke parallel geschalteten sowie über seinen Gateanschluß mit dem anderen Pol der Versorgungsspannungsquelle (V) verbundenen zweiten MOS-Feldeffekttransistors (3) des anderen Leitungstyps, die zwischen den Ausgang des bistabilen Schaltelements (LATCH) und den Drainanschluß des ersten MOS-Feldeffekttransistors (1) geschaltet sind, sowie aus einer zweiten Kapazität (6), die zwischen den Ausgang des bistabilen Schaltelements (LATCH) und den einen Pol der Versorgungsspannungsquelle (V) geschaltet ist, besteht.

3. Schaltungsanordnung nach Anspruch 1 oder 2,
**dadurch gekennzeichnet,** daß die beiden Inverter (4, 5) unsymmetrisch dimensioniert sind.

4. Schaltungsanordnung nach einem der Ansprüche 1 bis 3,
**dadurch gekennzeichnet,** daß die ein- und ausschaltbare Referenzspannungsquelle (REF) aus einem dritten MOS-Feldeffekttransistor (7) des anderen Leitungstyps, dessen Sourceanschluß an dem anderen Pol der Versorgungsspannungsquelle (V) angeschlossen ist sowie dessen Gateanschluß den Steuereingang und dessen Sourceanschluß den Ausgang der ein- und ausschaltbaren Referenzspannungsquelle (REF) bildet, sowie aus zwischen den Sourceanschluß des dritten MOS-Feldeffekttransistors (7) und den einen Pol der Versorungsspannungsquelle (V) geschalteten Dioden (8, 9) in Reihe besteht.

5. Schaltungsanordnung nach einem der Ansprüche 1 bis 4,
**dadurch gekennzeichnet,** daß die ein- und ausschaltbare Verzögerungssleitung (DELAY) aus einem vierten MOS-Feldeffekttransistor (10) des anderen Leitungstyps, dessen Drainanschluß mit dem anderen Pol der Versorgungsspannungsquelle (V) verbunden ist und dessen Gateanschluß den Steueranschluß der ein- und ausschaltbaren Verzögerungsleitung (DELAY) bildet, aus einem fünften MOS-Feldeffekttransistor (11) des anderen Leitungstyps, dessen Drainanschluß mit dem Sourceanschluß des vierten MOS-Feldeffekttransistors (10) verbunden ist und dessen Gateanschluß den Referenzeingang bildet, aus einem sechsten MOS-Feldeffekttransistor (12) des einen Leitungstyps, dessen Gateanschluß mit dem Gateanschluß des vierten MOS-Feldeffekttransistors (10) und dessen Drainanschluß mit dem Sourceanschluß des fünften MOS-Feldeffekttransistors (11) verbunden ist und dessen Sourceanschluß an den einen Pol der Versorgungsspannungsquelle (V) angschlossen ist, aus einer dritten Kapazität (13), die der Source-Drain-Strecke des sechsten MOS-Feldeffekttransistors (12) parallelgeschaltet ist, aus einem Entladewiderstand (14, 15), der der dritten Kapazität (13) parallelgeschaltet ist, aus zwei in Reihe geschalteten Invertern (16, 17), die einerseits an den Drainanschluß des sechsten MOS-Feldeffekttransistors (12) und andererseits an den Ausgang der ein- und ausschaltbaren Verzögerungsleitung (DELAY) angeschlossen sind, sowie aus einer vierten Kapazität (18), die zwischen den Ausgang der ein- und ausschaltbaren Verzögerungsleitung (DELAY) und den einen Pol der Versorgungsspannungsquelle (V) geschaltet ist, besteht.

6. Schaltungsanordnung nach einem der Ansprüche 1 bis 5,
**dadurch gekennzeichnet,** daß der Ausgang des bistabilen Schaltelements (LATCH) auf einen Eingang eines logischen Gatters (19) geführt ist, dessen anderer Eingang mit einem externen Rücksetzsignal (EXRES) beaufschlagt ist und dessen Ausgang das Rücksetzsignal führt.

7. Schaltungsanordnung nach einem der Ansprüche 1 bis 6,
**dadurch gekennzeichnet,** daß das Rücksetzsignal (RES) über eine Treiberstufe (DRIVER) geführt wird.

8. Schaltungsanordnung nach einem der Ansprüche 1 bis 7,
**dadurch gekennzeichnet,** daß die Kapazitäten (2, 6, 13, 18) durch MOS-Feldeffekttransistoren gebildet werden, bei denen Sourceanschluß und Drainanschluß miteinander verbunden sind.

9. Schaltungsanordnung nach einem der Ansprüche 1 bis 8,
**dadurch gekennzeichnet,** daß die Dioden (8, 9) durch MOS-Feldeffekttransistoren gebildet werden, bei denen Drainanschluß und Gateanschluß miteinander verbunden sind.

10. Schaltungsanordnung nach einem der Ansprüche 1 bis 9,
**dadurch gekennzeichnet**, daß die Schaltungsanordnung und weitere, an die Versorgungsspannungsquelle angeschlossene Schaltungsteile (C), die bei Auftreten des Rücksetzsignals (RES) zurückgesetzt werden, Bestandteil einer integrierten Schaltung (IC) sind.

## Claims

1. Circuit arrangement for generating a reset signal (RES)
having a bistable switching element (LATCH) which assumes a preferred state when a supply voltage (V) is applied, and in the case of which circuit arrangement an output carries the reset signal (RES) in the preferred state, having a reference voltage source (REF) which can be switched on and off, in the case of which a control input is connected to the output of the bistable switching element (LATCH) and which is switched on in the preferred state of the bistable switching element (LATCH), and having a delay line (DELAY) which can be switched on and off, in the case of which a control input is connected to the output of the bistable switching element (LATCH) and an output is connected to an input of the bistable switching element (LATCH) and in the case of which a reference input is connected to the reference voltage source (REF) which can be switched on and off, is switched on in the preferred state of the bistable switching element (LATCH) and, after the supply voltage (V) exceeds a reference value predetermined by the reference voltage source (REF) which can be switched on and off, toggles the bistable switching element (LATCH) with a time delay, out of the preferred state.

2. Circuit arrangement according to Claim 1, characterized in that the bistable switching element (LATCH) comprises a first MOS field-effect transistor (1) of the one conduction type, the source connection of which is connected to a pole of the supply voltage source (V) and the gate connection of which forms the input of the bistable switching element (LATCH), a first capacitor (2) which is connected between the other pole of the supply voltage source (V) and the drain connection of the first MOS field-effect transistor (1), two reverse-connected inverters (4, 5) and a second MOS field-effect transistor of the other conduction type, the source-drain path of which is connected in parallel with the said inverters and which is connected via its gate connection to the other pole of the supply voltage source (V), which inverters (4, 5) and transistor (3) are connected between the output of the bistable switching element (LATCH) and the drain connection of the first MOS field-effect transistor (1), and also a second capacitor (6) which is connected between the output of the bistable switching element (LATCH) and the one pole of the supply voltage source (V).

3. Circuit arrangement according to Claim 1 or 2, characterized in that the two inverters (4, 5) are dimensioned asymmetrically.

4. Circuit arrangement according to one of Claims 1 to 3, characterized in that the reference voltage source (REF) which can be switched on and off comprises a third MOS field-effect transistor (7) of the other conduction type, the source connection of which is connected to the other pole of the supply voltage source (V) and the gate connection of which forms the control input and the source connection of which forms the output of the reference voltage source (REF) which can be switched on and off, and also diodes (8, 9) connected in series between the source connection of the third MOS field-effect transistor (7) and the one pole of the supply voltage source (V).

5. Circuit arrangement according to one of Claims 1 to 4, characterized in that the delay line (DELAY) which can be switched on and off comprises a fourth MOS field-effect transistor (10) of the other conduction type, the drain connection of which is connected to the other pole of the supply voltage source (V) and the gate connection of which forms the control connection of the delay line (DELAY) which can be switched on and off, a fifth MOS field-effect transistor (11) of the other conduction type, the drain connection of which is connected to the source connection of the fourth MOS field-effect transistor (10) and the gate connection of which forms the reference input, a sixth MOS field-effect transistor (12) of the one conduction type, the gate connection of which is connected to the gate connection of the fourth MOS field-effect transistor (10) and the drain connection of which is connected to the source connection of the fifth MOS field-effect transistor (11) and the source connection of which is connected to the one pole of the supply voltage source (V), a third capacitor (13) which is connected in parallel with the source-drain path of the sixth MOS field-effect transistor (12), a discharge resistor (14, 15) which is connected in parallel with the third capacitor (13), two series-connected inverters (16, 17) which are connected, on the one hand, to the drain connection of the sixth MOS field-effect transistor (12) and, on the other hand, to the output of the delay line (DELAY) which can be switched on and off, and also a fourth capacitor (18) which is connected between the output of the delay line (DELAY) which can be switched on and off and the one pole of the supply voltage source (V).

6. Circuit arrangement according to one of Claims 1 to 5, characterized in that the output of the bistable switching element (LATCH) is fed to an input of a logic gate (19), the other input of which receives an external reset signal (EXRES) and the output of which carries the reset signal.

7. Circuit arrangement according to one of Claims 1 to 6, characterized in that the reset signal (RES) is passed via a driver stage (DRIVER).

8. Circuit arrangement according to one of Claims 1 to 7, characterized in that the capacitors (2, 6, 13, 18) are formed by MOS field-effect transistors, the source connection and drain connection of which are interconnected.

9. Circuit arrangement according to one of Claims 1 to 8, characterized in that the diodes (8, 9) are formed by MOS field-effect transistors, the drain connection and gate connection of which are interconnected.

10. Circuit arrangement according to one of Claims 1 to 9, characterized in that the circuit arrangement and further circuit sections (C) which are connected to the supply voltage source and are reset when the reset signal (RES) appears, are part of an integrated circuit (IC).

## Revendications

1. Montage destiné à générer un signal de remise à l'état initial (RES), comportant un élément de commutation bistable (LATCH), qui, lorsqu'une tension d'alimentation (V) lui est appliquée, prend un état préférentiel et dans lequel, dans l'état préférentiel, une sortie délivre le signal de remise à l'état initial (RES), comportant
une source de tension de référence (REF), qui peut être branchée et débranchée et dans laquelle une entrée de commande est reliée à la sortie de l'élément de commutation bistable (LATCH) et qui est branchée dans le cas où l'élément de commutation bistable (LATCH) est dans l'état préférentiel, et
une ligne à retard (DELAY), qui peut être branchée et débranchée, dans laquelle une entrée de commande est reliée à la sortie de l'élément de commutation bistable (LATCH) et une sortie est reliée à une entrée de l'élément de commutation bistable (LATCH), et dans laquelle une entrée de référence est raccordée à la source de tension de référence (REF) qui peut être branchée ou débranchée, qui est branchée lorsque l'élément de commutation bistable (LATCH) est dans l'état préférentiel et qui, lorsque la tension d'alimentation dépasse une valeur de référence prédéterminée par la source de tension de référence (V) pouvant être branchée et débranchée, fait basculer, d'une manière retardée dans le temps, l'élément de commutation bistable (LATCH) à partir de la position préférentielle.

2. Montage suivant la revendication 1, caractérisé par le fait que l'élément de commutation bistable (LATCH) est constitué d'un premier transistor à effet de champ MOS (1) d'un premier type de conductivité et dont la borne de source est reliée à un pôle de la source de tension d'alimentation (V) et dont la borne de grille forme l'entrée de l'élément de commutation bistable (LATCH), d'une première capacité (2), qui est branchée entre l'autre pôle de la source de tension d'alimentation (V) et la borne de drain du premier transistor à effet de champ MOS (1), de deux inverseurs (4,5) branchés selon un montage tête-bêche en parallèle, et d'un second transistor à effet de champ MOS (3) de l'autre type de conductivité et dont la voie source-drain est branchée en parallèle avec les inverseurs et dont la borne de grille est reliée à l'autre pôle de la source de tension d'alimentation (V), les inverseurs et ce transistor à effet de champ étant branchés entre la sortie de l'élément de commutation bistable (LATCH) et la borne de drain du premier transistor à effet de champ (MOS), ainsi que d'une seconde capacité (6) qui est branchée entre la sortie de l'élément de commutation bistable (LATCH) et le premier pôle de la source de tension d'alimentation (V).

3. Montage suivant la revendication 1 ou 2, caractérisé par le fait que les deux inverseurs (4,5) sont dimensionnés de manière à être dissymétriques.

4. Montage suivant l'une des revendications 1 à 3, caractérisé par le fait que la source de tension de référence (REF), qui peut être branchée et débranchée, est constituée d'un troisième transistor à effet de champ MOS (7) de l'autre type de conductivité, dont la borne de source est raccordée à l'autre pôle de la source de tension d'alimentation (V), dont la borne de grille forme l'entrée de commande et dont la borne de source forme la sortie de la source de tension de référence (REF), qui peut être branchée et débranchée, ainsi que, en série, de diodes (8,9) branchées entre la borne de source du troisième transistor à effet de champ MOS (7) et le premier pôle de la source de tension d'alimentation (V).

5. Montage suivant l'une des revendications 1 à 4, caractérisé par le fait que la ligne à retard (DELAY), qui peut être branchée et débranchée, est constituée d'un quatrième transistor à effet de champ (10) de l'autre type de conductivité, dont la borne de drain est raccordée à l'autre pôle de la source de tension d'alimentation (V) et dont la borne de grille forme la borne de commande de la ligne à retard (DELAY), qui peut être branchée et débranchée, d'un cinquième transistor à effet de champ MOS (11) de l'autre type de conductivité, dont la borne de drain est reliée à la borne de source du quatrième transistor à effet de champ MOS (10) et dont la borne de grille forme l'entrée de référence, d'un sixième transistor à effet de champ MOS (12) du premier type de conductivité et dont la borne de grille est reliée à la borne de grille du quatrième transistor à effet de champ MOS (10), dont la borne de drain est reliée à la borne de source du cinquième transistor à effet de champ MOS (11) et dont la borne de source est raccordée au premier pôle de la source de tension d'alimentation (V), d'une troisième capacité (13), qui est branchée en parallèle avec la voie source-drain du sixième transistor à effet de champ MOS (12), d'une résistance de décharge (14,15), qui est branchée en parallèle avec la troisième capacité (13), de deux inverseurs (16,17) branchés en série, qui sont raccordés d'une part à la borne de drain du sixième transistor à effet de champ MOS (12) et d'autre part à la sortie de la ligne à retard (DELAY), qui peut être branchée et débranchée, ainsi que d'une quatrième capacité (18), qui est branchée entre la sortie de la ligne à retard (DELAY), qui peut être branchée et débranchée, et le premier pôle de la source de tension d'alimentation (V) .

6. Montage suivant l'une des revendications 1 à 5, caractérisé par le fait que la sortie de l'élément de commutation bistable (LATCH) est raccordée à une entrée d'une porte logique (19), dont l'autre entrée reçoit un signal externe de remise à l'état initial (EXRES) et dont la sortie fournit le signal de remise à l'état initial.

7. Montage suivant l'une des revendications 1 à 6, caractérisé par le fait que le signal de remise à l'état initial (RES) est transmis par l'intermédiaire d'un étage d'attaque (DRIVER).

8. Montage suivant l'une des revendications 1 à 7, caractérisé par le fait que les capacités (2,6,13,18) sont formées de transistors à effet de champ MOS, dont les bornes de source et de drain sont reliées entre elles.

9. Montage suivant l'une des revendications 1 à 8, caractérisé par le fait que les diodes (8,9) sont formées de transistors à effet de champ MOS, dont la borne de drain et la borne de grille sont reliées entre elles.

10. Montage suivant l'une des revendications 1 à 9, caractérisé par le fait que le montage et d'autres parties de circuit (C), qui sont raccordées à la source de tension d'alimentation et qui sont remises à l'état initial lors de l'apparition du signal de remise à l'état initial (RES), font partie d'un circuit intégré (IC).
